# EUROPEAN PATENT APPLICATION

(11) **EP 4 390 542 A1**
(43) Date of publication of application: **26.06.2024**
(21) Application number: 22216468.3
(22) Date of filing: 23.12.2022
(51) Int. Cl.: G03F 7/00, H01L 21/687

(54) **OBJECT TABLE**

(71) Applicant: ASML Netherlands B.V., 5500 AH Veldhoven (NL)
(72) Inventor: ZHU, Jianqiang, 5500 AH Veldhoven (NL); ENGELEN, Johannes, Bernardus, Charles, 5500 AH Veldhoven (NL); KRUIZINGA, Matthias, 5500 AH Veldhoven (NL); ALLSOP, Nicholas Alan, 5500 AH Veldhoven (NL); KOEVOETS, Adrianus, Hendrik, 5500 AH Veldhoven (NL); GALAKTIONOV, Oleksiy, Sergiyovich, 5500 AH Veldhoven (NL); VAN DER WEKKEN, Michael, Christiaan, 5500 AH Veldhoven (NL); WARMING, Till, 5500 AH Veldhoven (NL)
(74) Representative: ASML Netherlands B.V.

(57) **Abstract**

An object table comprising a base having a planar surface, a substrate support or patterning device support comprising a clamp and a set of burls, the burls extending from the clamp and having distal ends adjacent to the planar surface of the base, wherein, the object table further comprises a compliant layer disposed between the burl distal ends and the planar surface of the base and a frictional layer which is in contact with the compliant layer.

## Description

### FIELD

The present invention relates to an object table. The object table may form part of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A substrate which is being patterned by a lithographic apparatus is held on an object table. The object table includes a substrate table which is configured to securely hold the substrate on the object table whilst the substrate is being patterned, and then to allow the substrate to be removed from the substrate table once patterning has been completed. The object table also includes a base which couples the substrate table to means for controlling the position and velocity of the object table. In some lithographic apparatus, the base may be a mirror block (i.e. include mirrors on its sides) so as to enable interferometric metrology. The substrate table typically abuts the base via projecting burls. A problem which may arise in connection with object tables is that it may be difficult to ensure that the substrate table is clamped sufficiently strongly to avoid slipping or relative displacement of the burls on the base during high acceleration of the object table. If slipping of a burl occurs during acceleration, then following the acceleration a distal end of the slipped burl will be displaced from its original position. This will cause distortion of a substrate held on the substrate table. Even distortions on the length scale of a few nanometers are detrimental to the operation of a lithography apparatus. The distortion may lead to poor quality patterns being formed on the substrate.

An object table may also be used to securely hold a patterning device in a lithographic apparatus. The object table when holding a patterning device may suffer from same problem.

It may be desirable to address the above problem in a manner which is not disclosed or suggested by the prior art.

### SUMMARY

According to a first aspect of the invention there is provided an object table comprising a base having a planar surface, a substrate support or patterning device support comprising a clamp and a set of burls, the burls extending from the clamp and having distal ends adjacent to the planar surface of the base, wherein, the object table further comprises a compliant layer disposed between the burl distal ends and the planar surface of the base and a frictional layer which is in contact with the compliant layer.

Advantageously, the compliant layer allows the burls to tolerate distortion of the base under high accelerations. The tolerance of base distortion is achieved because the compliant layer exhibits significant lateral compliance under a normal force. As a result, the burls are capable of elastically conforming to the base distortions, without the burls and base slipping relative to each other.

Further advantageously the frictional layer increases the force at which the surfaces between which it is disposed translate relative to each other and slip.

The compliant layer may be provided on the burl distal ends.

Advantageously, this economizes material use and time in manufacturing because the area of the burl distal ends is relatively small.

The compliant layer may be deposited by physical vapour deposition, chemical vapour deposition or sputter deposition.

The compliant layer may be provided on the planar surface of the base.

The frictional layer may be provided on the planar surface of the base.

The frictional layer may be provided on the burl distal ends.

The frictional layer may be provided on the compliant layer.

The object table may further comprise an additional compliant layer provided on the planar surface of the base.

The object table may further comprise an additional compliant layer provided on the burl distal ends.

The frictional layer may be provided on the additional compliant layer.

Advantageously, the provision of multiple compliant layers between the object table components reduces the effective shear strain for a given linear displacement of the burl, enhancing the compliance to base distortion.

Advantageously this reduces the risk of slipping of the compliant layer and an adjacent surface, such as the base.

According to a second aspect of the invention, there is provided an object support for placing on a base comprising a clamp and a set of burls which extend from the clamp, wherein a compliant layer is provided on distal ends of the burls.

The compliant layer may have an effective shear modulus of less than 100GPa.

This relatively low shear modulus (and thus low lateral stiffness) of the compliant layer(s) allows the substrate table to conform much more easily by shear deformation to base distortions.

The compliant layer may have a shear modulus of at least 1GPa.

The porosity of the compliant layer may be at least 5%.

Advantageously, the porosity of the compliant layer material microstructure enhances the compliance of the material relative to its bulk state, by reducing the effective shear modulus - in other words, lateral stiffness. By selecting the porosity of the compliant layer, a desired compliance can be obtained.

The compliant layer may have a porosity of up to 30%

The compliant layer being porous also provides the advantage that small contaminant particulates are adsorbed into the porous microstructure of the compliant layer. As a result, within limits, the sensitivity of the object table to flatness faults resulting from small particulates is reduced.

The compliant layer may be substantially composed of a transition metal nitride.

The compliant layer may be composed of a doped transition metal nitride.

Advantageously, many transition metal nitrides (specifically groups 4,5 and 6 transition metals including chromium nitride) are exceptionally thermally stable, corrosion- and wear-resistant. In particular, chromium nitride, which may be used, is relatively abundant and easily-handled in manufacture.

The compliant layer may have a substantially fibrous microstructure composed of a plurality of fiber-like grains.

The plurality of substantially columnar elements may extend in a direction substantially normal to a plane of the base, or a plane of the substrate support or patterning device support.

The columnar microstructure may be a zigzag microstructure.

Advantageously a compliant layer with a columnar or zig-zag elements has a high lateral compliance and relatively high normal stiffness so as to support normal force loads

The thickness of the compliant layer may be at least 0.1µm.

The thickness of the compliant layer allows a desired degree of lateral compliance to be achieved, whilst allowing ready manufacture by, for example, thin film sputter deposition. The compliant layer may be up to 100µm thick and preferably between approximately 1-10µm thick.

The frictional layer may have a coefficient of static friction greater than 0.1.

Advantageously, the frictional layer's relatively high dimensionless coefficient of static friction may prevent relative translational movement or slip between the burl and base under high acceleration, for example 100ms⁻² or 200ms⁻². The frictional layer may have a coefficient of static friction of 0.2 or greater.

The frictional layer may be substantially composed of a transition metal nitride.

The frictional layer may be substantially composed of Tungsten Nitride.

The frictional layer may be substantially composed of Titanium Nitride.

Advantageously, Tungsten Nitride and Titanium Nitride both exhibit high wear-resistance and a high coefficient of static friction and are capable of strong adhesion to their underlying surfaces.

The frictional layer may have a thickness of at least 50nm.

The frictional layer may be up to 5000nm thick. The frictional layer may have a thickness of approximately 200-1000nm.

Advantageously, frictional layers having a thickness of at least 50nm allows the use flattening processes, reducing the risk of flatness defects at the clamp and elsewhere.

According to a second aspect of the invention there is provided a method of fabricating an object table suitable for use in a lithographic apparatus, comprising providing a base having a planar surface, providing a substrate support or patterning device support comprising a clamp and a set of burls, the burls extending from the clamp and having distal ends adjacent to the planar surface of the base, and further providing a compliant layer disposed between the burl distal ends and the planar surface of the base, and a frictional layer which is in contact with the compliant layer.

The compliant layer may be deposited by physical vapour deposition.

The frictional layer may be deposited by physical vapour deposition.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a radiation source;
- Figure 2 schematically depicts in cross-section an object table according to an embodiment of the present invention;
- Figure 3 schematically depicts in cross-section a local view of a portion of the object table;
- Figure 4 schematically depicts in cross-section a local view of the portion of the object table of Figure 3 under acceleration;
- Figure 5A schematically depicts in cross-section a portion of the object table according to an alternative embodiment of the present invention;
- Figure 5B schematically depicts in cross-section a portion of the object table according to an alternative embodiment of the present invention;
- Figure 5C schematically depicts in cross-section a portion of the object table according to an alternative embodiment of the present invention;
- Figure 6A schematically depicts in cross-section a portion of the object table according to an alternative embodiment of the present invention;
- Figure 6B schematically depicts in cross-section a portion of the object table according to an alternative embodiment of the present invention; and
- Figure 7 schematically depicts in cross-section and with more detail a portion of the object table according to an embodiment of the present invention.

### DETAILED DESCRIPTION

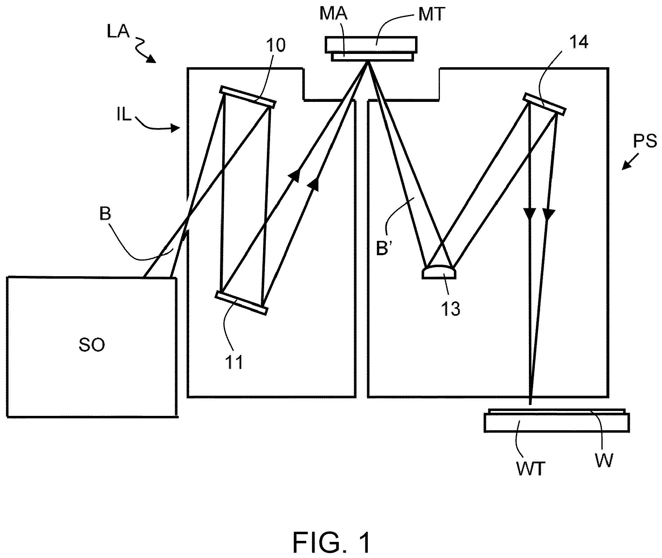

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a patterning device table MT configured to support a patterning device MA (e.g., a mask), a projection system PS and a substrate table WT configured to support a substrate W. The patterning device table MT and substrate table WT are examples of object tables, which may be according to an embodiment of the invention.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

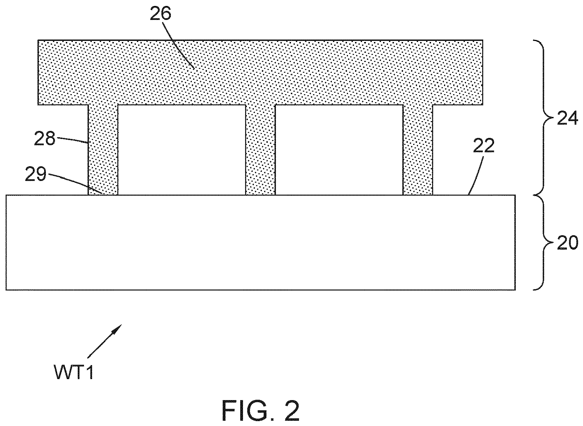

Figure 2 schematically depicts in cross section part of one of the object tables of Figure 1 (in this case the substrate table WT1). The object table comprises a base 20 having a planar surface 22 and a substrate support 24. The substrate support 24 comprises a clamp 26 and a set of burls 28. The burls extend from the clamp 26 and have distal ends 29 adjacent to, and forming a free interface with, the planar surface 22 of the base 20. The burls 28 may form a free interface with the base 20. Only one burl is labelled in the interests of clarity.

Here, a free interface is taken to mean an interface with no tensile cohesion.

The base 20 may be substantially fabricated from glass material. The glass material may for example be cordierite or Zerodur (available from Schott AG of Mainz, Germany). The base 20 may have a low coefficient of thermal expansion. The substrate support 24 (including the burls 28) may be substantially fabricated from Silicon Carbide (SiSiC) or XG Glass (available from Corning Inc. of New York, USA). The substrate support 24 may have a low coefficient of thermal expansion.

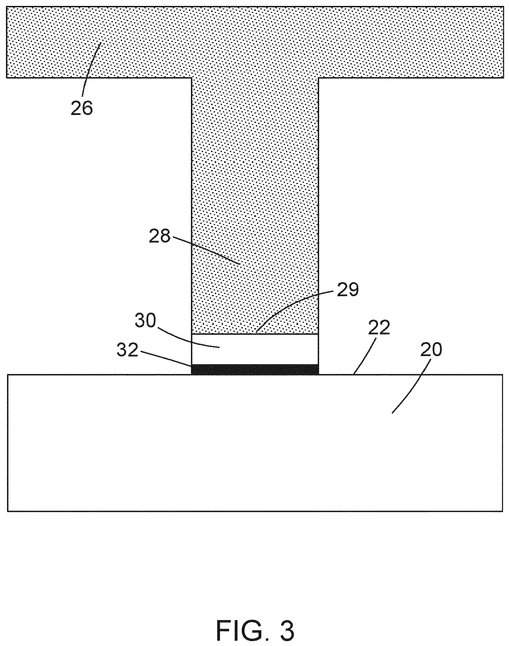

Figure 3 shows a detailed view of one burl 28 and adjacent portions of the base 20 and clamp 26. It will be appreciated that other burls will be substantially the same as this burl. The burl 28 comprises a compliant layer 30 located on the burl distal end 29 and a frictional layer 32 located on the compliant layer. Thus, the depicted arrangement provides a compliant layer 30 between the burl distal ends 29 and the planar surface 22 of the base 20.

The frictional layer 32 forms a free interface with the planar surface 22 of the base 20. It will be appreciated that the free interface is the interface at which friction solely acts.

When the clamp is activated, it presses the burl 28 (and other burls) onto the base 20. The substrate support 24 is thereby secured on the base 20.

The compliant layer 30 is characterized in that it has a relatively low shear modulus of between 1-100GPa. The compliant layer may have a thickness of between 0.1-100µm. The compliant layer preferably has a thickness of between 1-10µm. The compliant layer may allow a lateral displacement or deflection of around 20nm before slipping.

A low shear modulus and high compliant layer thickness, for example the above values, reduces the effective shear strain for a given linear displacement of the burl, enhancing the compliance to base distortion. The compliant layer is capable of elastically conforming to deformation of the base 20.

The compliant layer 30 may have a normal stiffness of at least around 5 × 10⁶N/m, and for example up to around 5×10⁸N/m. The compliant layer 30 may preferably have a normal stiffness of 5-7×10⁷ N/m. The relatively high normal stiffness allows the compliant layer 30 to support the substrate and substrate support 26.

One method of achieving a desired shear modulus for the compliant layer is via selection of the porosity of the compliant layer. The porosity of the compliant layer may be at least 5%. A porosity of 5% may be sufficient to provide a significant degree of lateral compliance. A higher porosity will provide a greater degree of lateral compliance, and so may be desirable (for example depending upon the level of acceleration that will be experienced by the object table). The porosity of the compliant layer may be at least 10%, and may be at least 15%. The porosity of the compliant layer may be up to 30%.

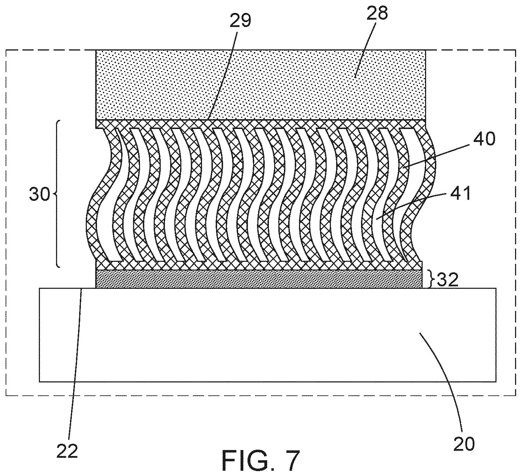

The compliant layer porosity may be achieved by using a fibrous microstructure. Referring to Figure 7, which schematically depicts an embodiment of the object table having a compliant layer 30, the compliant layer may have a fibrous microstructure comprising fiber-like grains 40 (or fibers) of a generally linear shape. The fibers 40 extend in a direction generally normal to the plane of the substrate support (i.e. generally away from the burl distal ends). The fibers define interstices 41, providing the compliant layer with a desired porosity.

It will be appreciated that there are many other porous microstructures available. The microstructure of any deposited material may be controlled so as to provide a desired set of properties, for example a low (lateral) shear modulus and/or a high coefficient of static friction.

In one alternative embodiment, the compliant layer 30 may have a 'zigzag' microstructure comprising a plurality of 'zigzag' members, each resembling a sawtooth wave. The 'zigzag' members may extend generally normal to a plane of the substrate support.

In the presently-described embodiments, the compliant layer 30 and/or frictional layer 32 may be composed of a transition metal nitride, for example Tungsten nitride, Tantalum nitride, Titanium nitride or Chromium nitride, or doped versions thereof. These transition metal nitrides are well-suited to the present application, being thermally-stable, wear- and corrosion resistant.

The friction layer 32 may be characterized in that it can provide an interface having a relatively high coefficient of static friction. For example, the coefficient of static friction may be at least 0.1, may be for example 0.14 and may preferably be 0.2 or greater. A coefficient of static friction of 0.1 may be sufficient to prevent slip at a high acceleration, but a coefficient of static friction of 0.14, or still better 0.2, provide even greater resistance to slip and/or prevent slip at even greater accelerations.

The thickness of the frictional layer 32 may be in the range 50-5000nm, preferably in the range 200-1000nm.

The frictional layer 32 may be formed from the same material as the compliant layer but with a different microstructure. For example, instead of the fibrous structure of the compliant layer 30, the frictional layer 32 may have has a columnar grain or a nanocrystalline fine grain microstructure.

A frictional layer may be provided by means of a different composition (e.g. chemical surface treatment) or by surface engineering methods (e.g. plasma treatment).

During fabrication of the object table, the frictional layer 32 may be subject to flattening operations, such as polishing, so as to provide a desired flatness of the bottom of the substrate table. Such operations are subtractive. This may impose a minimum thickness of the frictional layer of around 50nm (as stated above) and make layers thicker than 50nm more attractive in terms of manufacturing.

The frictional layer 32 may be composed of a transition metal nitride, which may or may not be chemically identical to the compliant layer 30, for example Tungsten nitride or Titanium nitride. These transition metal nitrides are well-suited to the present application, being wear-resistant, having good cohesion or adhesion with the compliant layer 30.

The microstructural configuration and thickness of any deposited layers, for example the compliance and/or frictional layers can be controlled by varying process variables during deposition. For example, a layer of material, such as transition metal nitride, may be deposited on a surface by means of physical vapor deposition (PVD). A columnar, fibrous or fine grained nanocrystalline microstructure may be deposited by selection of process parameters. PVD process parameters include ambient composition, temperature and plasma energy.

Other layer deposition methods may also be used, such as chemical vapor deposition (CVD).

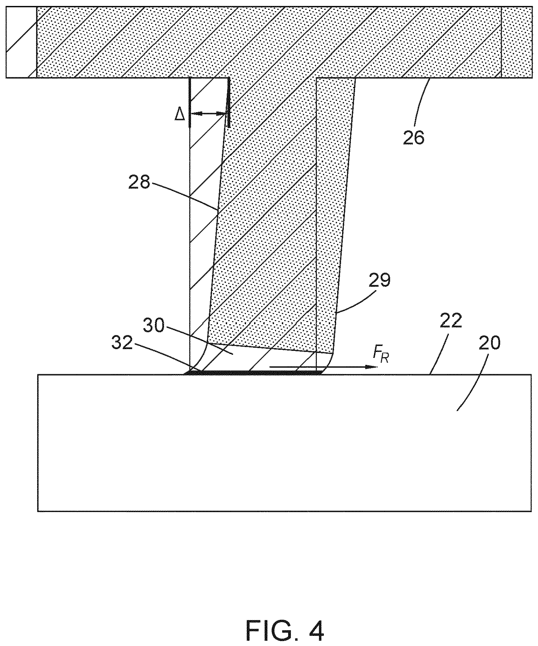

Use according to an embodiment of the invention is now described with reference to Figure 4. The embodiment is described in connection with a substrate on a substrate table. However, an equivalent embodiment applies for a patterning device on a patterning device table.

A substrate is loaded onto the substrate support 24. The substrate support and the substrate are then electrostatically clamped so as to secure them in place during movement and acceleration of the object table and substrate. The clamping secures the substrate (not depicted) to the substrate support 24. In addition, the clamping secures the substrate support 24 to the base 20. In both cases a compressive clamping force oriented substantially normal to the planar surface 22 of the base 20 applies. The compressive clamping force between the substrate support 24 and the base 20 induces a high frictional threshold for relative motion between the base 20 and substrate support 24.

High acceleration of the object table, comprising the base 20, is desirable in order to increase throughput of a lithographic apparatus, such as LA.

In use, under high object table acceleration, distortions of the base 20 arise. Distortions of the base 20 may compel deflection or slip of the burls under a normal clamping force. Here, high acceleration may be, for example, around 40, around 100, or around 200ms⁻².

The burls 28 deflect so as to conform to the distortions of the base 20. The deflection induces a lateral restoring force in the burl. The lateral restoring force increases with deflection.

Slip can be understood as the circumstance in which the deflection of a burl 28 reaches a point where the lateral restoring force of the burl exceeds the static friction maintaining static contact with a portion of the planar base. There is no longer static equilibrium, and as a result relative motion, or slip, occurs between the burl distal end 29 and the base planar surface 22.

Figure 4 schematically illustrates a burl 28 of under a deflection Δ, and also depicts the adjacent portions of the base 20 and clamp 26. The configuration of the same burl and adjacent portions of the clamp 26 when the object table is at rest (semi-transparent, 28a and 26a respectively) is superimposed, so as to clarify the nature of deformation. The lateral restoring force in the burl is labelled as *F_{R}.*

Depending on the characteristics of the base deformation, the deflection of the burl may vary. The provision of a compliant layer 30 reduces the lateral force F_{R} for a given burl deflection magnitude Δ, because of its relatively low shear modulus (compared with a conventional arrangement in which no compliant layer is present). Reduced lateral force *F_{R}* from burl deflection for a given magnitude of deflection Δ means that the deflection magnitude at which static friction is overcome is increased. Much larger deflection and thus greater base distortion is required to cause slip. In other words, slip is less likely to occur.

The frictional layer increases the force threshold for slip for a given normal clamping force. Thus in combination, the compliant and frictional layers cooperate to increase the force at which slipping occurs. As such, the object table of the present invention can be subjected to higher acceleration without burls slipping.

It will be appreciated that the present invention is not limited to the above-described embodiment. Indeed, there may be many structural and compositional variants, some of which are presented below.

It will be appreciated that the following alternative embodiments are comparable structurally and compositionally to the embodiment described with reference to Figures 2-4. Therefore, like numerals will refer to like elements where appropriate.

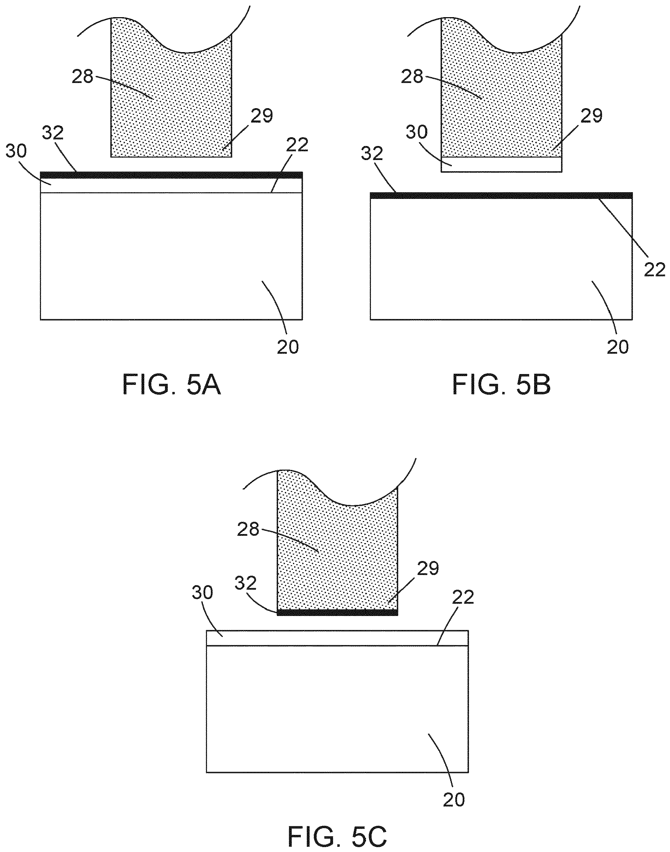

Fig 5A schematically illustrates another embodiment of the present invention. It shows a detailed view of the burl 28 and adjacent portion of the base 20. It will be appreciated that other instances of the burls may be substantially the same. A compliant layer 30 is provided on the planar surface 22 of base 20 and a frictional layer 32 is provided on the compliant layer.

The frictional layer 32 forms a free interface with the distal end 29 of the burl 28.

Fig 5B schematically illustrates another embodiment of the present invention. It shows a detailed view of the burl 28 and adjacent portions of the base 20. A compliant layer 30 is provided on the distal end 29 of the burl 28 and a frictional layer 32 is provided on the planar surface 22 of the base 20.

The frictional layer 32 forms a free interface with the compliant layer 30.

Fig 5C schematically illustrates another embodiment of the present invention. It shows a detailed view of the burl 28 and adjacent portions of the base 20. A frictional layer 32 is provided on the distal end 29 of the burl 28 and a compliant layer 30 is provided on the planar surface 22 of the base 20.

The frictional layer 32 forms a free interface with the compliant layer 30.

In some alternative embodiments the object table may comprise multiple compliant layers, for example two, compliant layers.

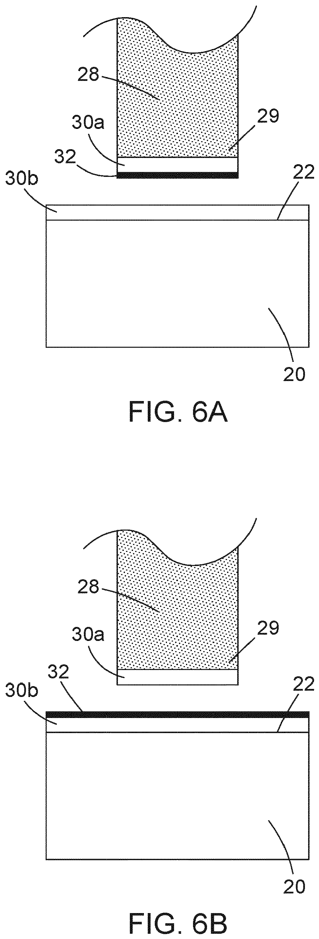

An alternative embodiment having two compliant layers is schematically illustrated in Figure 6A. Figure 6A shows a detailed view of the burl 28 and adjacent portions of the base 20. A first compliant layer 30a is provided on the planar surface 22 of the base 20 and a frictional layer 32 is provided on the first compliant layer 30a. A second compliant layer 30b is provided on the planar surface 22 of the base 20.

The frictional layer 32 could also be provided on the second compliant layer 30b, as shown in Figure 6B, or even on both the first and second compliant layers.

The frictional layer 32 forms a free interface with a compliant layer.

In general, the embodiments described with reference to Figures 5A-6B fulfil their function in substantially the same way (e.g. as described in relation to Figure 4). By providing a compliant layer, deflection forces are reduced. By providing a frictional layer at the free interface the deflection force necessary for slip is increased. The effects of the frictional and compliant layers are thus synergistic in increasing the acceleration tolerance of the object table.

Embodiments of the invention refer to a compliant layer being provided on a structure such as the burl distal ends. The compliant layer may be provided by deposition, or any other suitable process. Embodiments of the invention refer to a frictional layer being provided on a structure such as the planar surface of the base. The frictional layer may be provided by deposition, or any other suitable process.

Although the above-described embodiments have primarily been described in relation to use in an EUV lithographic apparatus, it will be appreciated that the above described object tables would also be applicable in, for example, deep-ultraviolet (DUV) lithographic apparatus.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Examples

1. An object table comprising:
   a base having a planar surface;
   a substrate support or patterning device support comprising:
      a clamp and a set of burls, the burls extending from the clamp and having distal ends adjacent to the planar surface of the base;
   wherein, the object table further comprises:
      a compliant layer disposed between the burl distal ends and the planar surface of the base; and
      a frictional layer which is in contact with the compliant layer.
2. The object table according to example 1, wherein the compliant layer is provided on the burl distal ends.
3. The object table according to example 1, wherein the compliant layer is provided on the planar surface of the base.
4. The object table of example 2 wherein the frictional layer is provided on the planar surface of the base.
5. The object table of example 3 wherein the frictional layer is provided on the burl distal ends.
6. The object table of examples 2 or 3 wherein the frictional layer is provided on the compliant layer.
7. The object table of example 2, further comprising an additional compliant layer provided on the planar surface of the base.
8. The object table of example 3, further comprising an additional compliant layer provided on the burl distal ends.
9. The object table of example 7 or 8, wherein the frictional layer is provided on the additional compliant layer.
10. The object table according to any preceding example, wherein the compliant layer has an effective shear modulus of less than 100GPa.
11. The object table according to any preceding example, wherein the porosity of the compliant layer is at least 15%.
12. The object table according to any preceding example, wherein the compliant layer is substantially composed of a transition metal nitride.
13. The object table of any preceding example wherein the compliant layer is composed of a doped transition metal nitride.
14. The object table of any preceding example wherein the compliant layer has a substantially fibrous microstructure composed of a plurality of fiber-like grains.
15. The object table of example 14, wherein the plurality of substantially columnar elements extend in a direction substantially normal to a plane of the base or a plane of the substrate support or patterning device support.
16. The object table of example 14 or example 15, wherein the columnar microstructure is a zigzag microstructure.
17. The object table according to any examples 12-16, wherein the thickness of the compliant layer is at least 0.1µm.
18. The object table of any preceding example, wherein the frictional layer has a coefficient of static friction greater than 0.1.
19. The object table of any preceding example wherein the frictional layer is substantially composed of a transition metal nitride.
20. The object table of example 19 wherein the frictional layer is substantially composed of Tungsten Nitride.
21. The object table of example 19 wherein the frictional layer is substantially composed of Titanium Nitride.
22. The object table according to any of examples 19-21, wherein the frictional layer has a thickness of at least 50nm
23. A method of fabricating an object table suitable for use in a lithographic apparatus, comprising:
   providing a base having a planar surface;
   providing a substrate support or patterning device support comprising:
      a clamp and a set of burls, the burls extending from the clamp and having distal ends adjacent to the planar surface of the base; and,
   further providing:
      a compliant layer disposed between the burl distal ends and the planar surface of the base; and
      a frictional layer which is in contact with the compliant layer.

## Claims

1. An object table comprising:
a base having a planar surface;
a substrate support or patterning device support comprising:
a clamp and a set of burls, the burls extending from the clamp and having distal ends adjacent to the planar surface of the base;
wherein, the object table further comprises:
a compliant layer disposed between the burl distal ends and the planar surface of the base; and
a frictional layer which is in contact with the compliant layer.

2. The object table according to claim 1, wherein the compliant layer is provided on the burl distal ends.

3. The object table according to claim 1, wherein the compliant layer is provided on the planar surface of the base.

4. The object table of claim 2 wherein the frictional layer is provided on the planar surface of the base.

5. The object table of claim 3 wherein the frictional layer is provided on the burl distal ends.

6. The object table of claims 2 or 3 wherein the frictional layer is provided on the compliant layer.

7. An object support for placing on a base comprising a clamp and a set of burls which extend from the clamp, wherein a compliant layer is provided on distal ends of the burls, which object support is for a semiconductor manufacturing apparatus.

8. The object table or the object support according to any preceding claim, wherein the compliant layer has an effective shear modulus of less than 100GPa or/and wherein the porosity of the compliant layer is at least 5%.

9. The object table or the object support according to any preceding claim, wherein the compliant layer is substantially composed of a transition metal nitride or a doped transition metal nitride, and wherein the compliant layer has a substantially fibrous microstructure composed of a plurality of fiber-like grains.

10. The object table or the object support of claim 9, wherein the plurality of substantially columnar elements extend in a direction substantially normal to a plane of the base or a plane of the substrate support or patterning device support, optionally wherein the columnar microstructure is a zigzag microstructure.

11. The object table or the object support according to any claims 9-10, wherein the thickness of the compliant layer is at least 0.1µm, or/and
wherein the frictional layer has a coefficient of static friction greater than 0.1.

12. The object table or the object support of any preceding claim wherein the frictional layer is substantially composed of a transition metal nitride.

13. The object table or the object support of claim 12 wherein the frictional layer is substantially composed of Tungsten Nitride or Titanium Nitride.

14. The object table or the object support according to any of claims 12-13, wherein the frictional layer has a thickness of at least 50nm

15. A semiconductor manufacturing apparatus comprising the object table or the object support according to any preceding claims.
